Europäisches Patentamt

European Patent Office

Office européen des brevets

(11) Veröffentlichungsnummer: **0 201 758 B1**

(12) **EUROPÄISCHE PATENTSCHRIFT**

(45) Veröffentlichungstag der Patentschrift: **29.01.92**

(21) Anmeldenummer: **86105415.3**

(22) Anmeldetag: **18.04.86**

(51) Int. Cl.⁵: **H03D 3/00**, H03H 17/06

(54) **Demodulator für frequenzmodulierte Signale in digitaler Form.**

(30) Priorität: **15.05.85 DE 3517485**

(43) Veröffentlichungstag der Anmeldung:
**20.11.86 Patentblatt 86/47**

(45) Bekanntmachung des Hinweises auf die
Patenterteilung:
**29.01.92 Patentblatt 92/05**

(84) Benannte Vertragsstaaten:
**DE FR GB IT**

(56) Entgegenhaltungen:
**EP-A- 0 080 014**
**DE-A- 2 262 652**
**DE-A- 3 302 550**
**US-A- 3 979 701**

(73) Patentinhaber: **Blaupunkt-Werke GmbH**
**Robert-Bosch-Strasse 200**
**W-3200 Hildesheim(DE)**

(72) Erfinder: **Kammeyer, Karl Dirk, Prof. Dr. Ing.**
**Finkennest 6**
**W-2110 Buchholz i.d.N.(DE)**
Erfinder: **Tobergte, Wolfgang, Dipl.-Ing.**
**Wohlwillstrasse 31**
**W-2000 Hamburg 4(DE)**

(74) Vertreter: **Eilers, Norbert, Dipl.-Phys.**
**Blaupunkt-Werke GmbH Robert-**
**Bosch-Strasse 200**
**W-3200 Hildesheim(DE)**

**Beschreibung**

Das Schutzrecht betrifft einen neuen Demodulator für frequenzmodulierte Signale in digitaler Form.

Durch die europäische Patentanmeldung EP-A-80014 ist ein solcher Demodulator bekannt geworden. Der Demodulator umfaßt am Ausgang der ZF-Mischstufe einen breitbandigen analogen Bandpaß als Vorfilter, dem ein A/D-Wandler nachgeschaltet ist. Die analoge Vorfilterung soll eine subharmonische Abtastung des Ausgangssignals der ZF-Mischstufe ermöglichen. Im Anschluß von digitalen Multiplikatoren sind Tiefpaßfilter geschaltet, welche das eigentliche Nutzsignal ausfiltern. In einer nachfolgenden Schaltung werden die so gewonnenen digitalen Signale zur Erzeugung der NF-Signale aufbereitet.

In der genannten europäischen Patentanmeldung sind die Zusammenhänge zwischen der Vorfilterbandbreite einerseits und der erforderlichen Abtastfrequenz andererseits aufgezeigt. Es wird angestrebt, einmal eine wirksame Reduktion der Abtastfrequenz durch entsprechend gering gewählte Vorfilterbandbreiten zu erreichen, zum anderen aber von hinreichend breiten analogen Vorfiltern auszugehen, damit das später digital herauszufilternde Signal nicht durch die ungünstigen Eigenschaften der Analogfilter in Phase und Amplitudengang verzerrt wird. Als Kompromiß wird bei dem bekannten Demodulator eine Vorfilterbandbreite angesetzt, die wesentlich größer ist, als die Bandbreite des zu empfangenden Signals.

Beim praktischen Einsatz des bekannten digitalen Demodulators treten jedoch Schwierigkeiten im Zusammenhang mit den Dynamikanforderungen an den Analog-Digital-Wandler auf. Wegen der deutlich größer als die eigentliche ZF-Bandbreite gewählten vorfilterbandbreite ist nämlich nicht auszuschließen, daß neben dem Nutzsender eine Reihe von Nachbarsendern in das Band fällt, wobei die Pegel der Nachbarsender erheblich über dem des Nutzsenders liegen können. Dies ist insbesondere dann zu erwarten, wenn sich der Empfangsort - beispielsweise bei einem Empfänger in einem Kraftfahrzeug - ständig ändert. Für ein einwandfreies Arbeiten des Analog-Digital-Wandlers Um gleichwohl auch schwache Sender neben einem starken Sender selektieren zu können, ist es beim Stand der Technik erforderlich, Analog-Digital-Wandler mit einer sehr hohen Auflösung im Hinblick auf eine hinreichende Dynamikreserve zu verwenden, was jedoch in Anbetracht des schnellen erforderlichen Zeitverhaltens Schwierigkeiten bereitet. Der bekannte digitale Demodulator ist somit aufgrund des zu betreibenden Aufwandes bei der Analog-Digital-Wandlung nur mit großem Aufwand realisierbar.

In der eigenen älteren Patentanmeldung EP-A-0184018 (veröffeutlicht aus 11.06.86) von welcher die Erfindung ausgeht, ist demgegenüber die Anwendung schmalbandiger Vorfilter vorgeschlagen, um zu verhindern, daß neben dem Nutzsignal weitere Nachbarsender in das Band des analogen Vorfilters fallen. In dem Stand der Technik gemäß der europäischen Patentanmeldung EP-A-184.018 ist demgegenüber die Anwendung schmalbandiger Vorfilter vorgeschlagen, um zu verhindern, daß neben dem Nutzsignal weitere Nachbarsender in das Band des analogen Vorfilters fallen.

Die schmalbandige ZF-Filterung, die nun durch das analoge Vorfilter bedingt ist, bringt allerdings große Phasen- und Dämpfungsverzerrungen mit sich. Deshalb wird bei dem Demodulator gemäß der älteren Patentanmeldung weiter vorgeschlagen, anstelle des Tiefpasses des oben beschriebenen bekannten Demodulators ein Entzerrernetzwerk zu verwenden, das die Phasen- und Dämpfungsverzerrungen des schmalbandigen Vorfilters ausgleicht bzw. behebt. Der digitale Entzerrer in Form des Entzerrernetzwerks hat nicht mehr die Aufgabe einer Senderselektion, sondern dient der Kompensation der nichtidealen Eigenschaften des analogen Vorfilters.

Da Störungen durch starke Sender in der Nähe eines schwachen Senders nun nicht mehr auftreten können, ist es möglich, die Dynamikanforderungen bezüglich des Nutzsignals zu reduzieren, und ferner kann wegen der geringeren Bandbreite des zu verarbeitenden Signales auch die Abtastfrequenz des Analog-Digital-Wandlers reduziert werden.

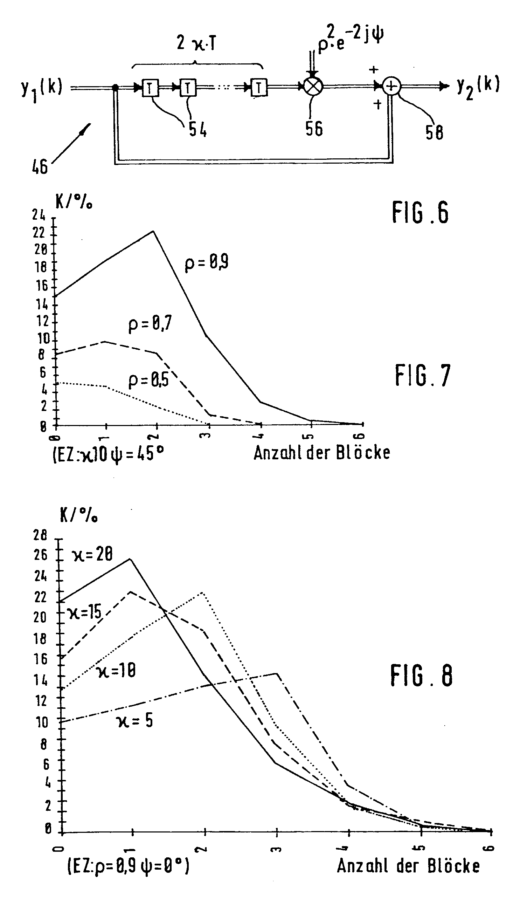

Neben den soweit geschilderten Gesichtspunkten ist generell bei einem Empfänger auch der Aspekt einer Unterdrückung des Mehrwegeempfanges von erheblicher Bedeutung. In der älteren Patentanmeldung ist in diesem Zusammenhang schon erwähnt, daß die dort als digitale Entzerrer verwendeten nichtrekursiven Filter auch zur Kompensation des Mehrwegeempfanges geeignet sind, und in Fig. 6 der genannten Patentanmeldung ist ein entsprechend aufgebautes nichtrekursives Filter dargestellt.

Dem Vorteil der Reduktion der nichtlinearen Verzerrungen unter dem Einfluß von Mehrwegeempfang durch ein digitales Entzerrernetzwerk steht allerdings der nachteilige Umstand entgegen, daß für die konkrete technische Realisierung eines entsprechenden nichtrekursiven Filters ein großer Hardware-Aufwand zu betreiben ist. Dadurch werden die entsprechenden Empfänger teuer und gegebenenfalls unwirtschaftlich in der Herstellung.

Hier greift die Erfindung nach dem Anspruch 1 ein, der die Aufgabe zugrunde liegt, einen digitalen Demodulator mit einem Entzerrernetzwerk anzugeben, welches eine ebenso gute Kompensation von Mehrwegeempfang ermöglicht und gleichwohl mit geringerem Aufwand zu realisieren ist.

EP 0 201 758 B1

Die Lösung dieser Aufgabe erfolgt bei dem im Gattungsbegriff des Hauptanspruchs vorausgesetzten Demodulator dadurch, daß die Entzerrer zur Kompensation von Mehrwegeempfang durch einen nichtrekursiven Kaskadenentzerrer mehreren in Reihe gespalteten Entzerrern gebildet sind, wobei jeder Entzerrerblock eine Erhöhung der Phasendrehung und der Laufzeit sowie eine Reduzierung des Reflexionsfaktors des im Eingangssignal enthaltenen reflektierten Anteils bewirkt.

Ein wesentlicher Gesichtspunkt der Erfindung ist die vorgesehene Kaskadenstruktur durch mehrere nacheinander geschaltete einzelne Teilentzerrer. Dabei ist es von Vorteil, daß jeder Teilentzerrer mit geringstmöglichem Hardware-Aufwand zu realisieren ist, und daß dadurch der gesamte Aufwand einer aus mehreren Entzerrern bestehenden Kaskade als wesentlich geringer angesehen werden kann, als im Falle der Transversalrealisierung gemäß der in der genannten älteren Patentanmeldung dargelegten Form.

Gleichwohl wird eine erhebliche Reduktion von Mehrwegeempfang erzielt. In der Hintereinanderschaltung von Teilentzerrern zu einer Kaskade wird, über drei Blöcke hinausgehend, die in einem vorhergehenden Entzerrerblock schon erzielte Kompensation von Mehrwegeempfang in dem nachfolgenden Block weiter verbessert, wobei in jedem Entzerrerblock die Phasendrehung und die Laufzeit verdoppelt und der Reflexionsfaktor - für den Fall, daß die Amplitude der Refelxion kleiner als "1" ist - nach einer exponentiellen Funktion $(\rho)^{2n}$ reduziert wird. Im einzelnen werden die mathematischen Zusammenhänge weiter unten bei der Figurenbeschreibung noch näher erläutert.

Vorteilhafte Ausgestaltungen und Weiterbildungen der Erfindung - auch für den Fall, daß die Amplitude größer als "1" ist - sind in den Unteransprüchen angegeben und der Zeichnung zu entnehmen.

Nachfolgend wird die Erfindung an Hand der in der Zeichnung dargestellten Ausführungsbeispiele näher erläutert, wobei zum besseren Verständnis auch ausführlich auf die ältere Patentanmeldung gemäß dem Gattungsbegriff des Hauptanspruchs eingegangen wird. Es zeigen:

| Fig. 1 | eine schematische Darstellung der Filterstruktur bei dem in der älteren Patentanmeldung vorgeschlagenen Demodulator, |
| Fig. 2 | einen Entzerrerzweig bei dem Demodulator gemäß Fig. 1, |
| Fig. 3 | eine Darstellung eines modifizierten Entzerrerzweiges zur Kompensation einer Einfachreflexion bei dem Demodulator gemäß Fig. 1, |
| Fig. 4 | eine schematische Prinzipdarstellung eines aus mehreren Entzerrerblöcken bestehenden Kaskadenentzerrers gemäß der Erfindung, |
| Fig. 5 | eine Prinzipdarstellung eines nichtrekursiven Entzerrers gemäß dem ersten Entzerrerblock in Fig. 4, |
| Fig. 6 | eine Darstellung gemäß Fig. 5, für den zweiten Entzerrerblock in Fig. 4, |
| Fig. 7 und 8 | jeweils ein Diagramm für den Klirrfaktor eines demodulierten Signales als Funktion der Anzahl der verwendeten Entzerrerblöcke, |
| Fig. 9 | eine schematische Darstellung zur Verdeutlichung des hardwaremäßigen Aufbaus eines Entzerrers, und |
| Fig. 10 | eine Prinzipdarstellung für einen Entzerrerblock, für den Fall einer Amplitude der Reflexion von größer als 1. |

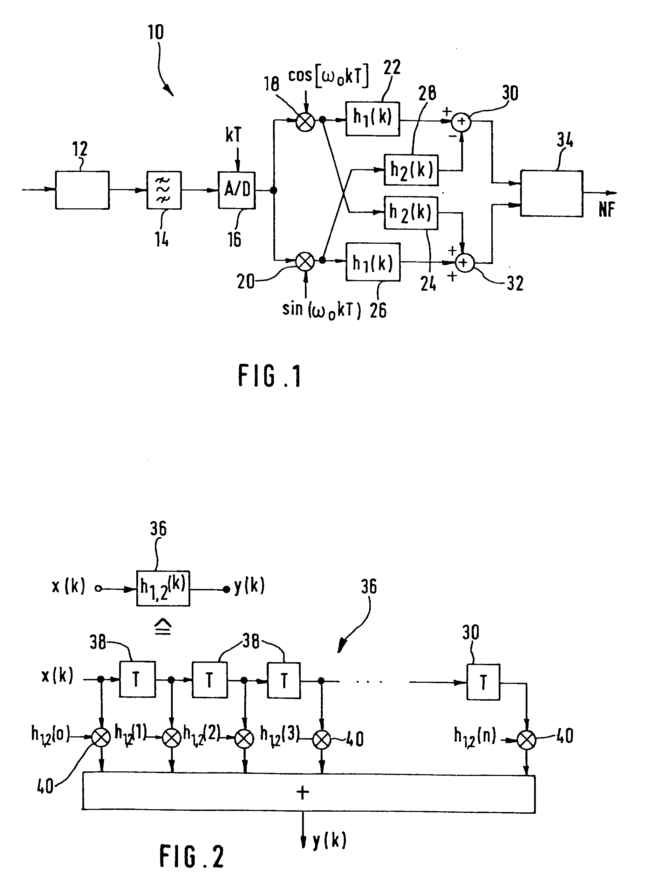

In der Zeichnung betreffen Fig. 1 - 3 zunächst einen digitalen Demodulator, von dem die Erfindung ausgeht, und der in der eigenen älteren Patentanmeldung P 34 44 449.1 beschrieben ist. Fig. 1 zeigt einen hier interessierenden Teil eines digitalen Empfängers 10. Einem ZF-Mischer 12 ist ein Bandpass 14 nachgeschaltet, auf welchen ein Analog-Digital-Wandler 16 folgt.

Durch den Einsatz digitaler Netzwerke, umfassend die nichtrekursiven Filter 22,24,26 und 28, werden bei dem vorgeschlagenen digitalen Demodulator die nichtidealen Eigenschaften des analogen Bandpasses 14 ausgeglichen. Wie in Fig. 1 zu erkennen ist, handelt es sich bei der Filterstruktur um Transversalformen.

An den digitalen Ausgang des Analog-Digital-Wandlers 16 sind digitale Multiplizierer 18 und 20 angeschlossen, wobei im Multiplizierer 18 die Multiplikation mit einer Kosinusfunktion mit der nach der Abtastung vorliegenden Tragerfrequenz $f_o$, während im Multiplizierer 20 die Multiplikation 20 mit einer Sinusfunktion gleicher Frequenz erfolgt.

Gemäß der Darstellung in Fig. 1 sind im Anschluß an die Multiplizierer 18 und 20 jeweils zwei nichtrekursive Filter mit je einem Addierer 30 und 32 verbunden, und die Ausgänge der digitalen Addierer 30 und 32 führen zu einem Demodulator 34, um die NF-Signale zu erzeugen.

In der erwähnten älteren Patentanmeldung wird bereits gezeigt, daß die Filterstruktur nach Fig. 1 auch zur Kompensation von Mehrwegeempfang geeignet ist. Unterstellt man nur eine einzige Reflexion mit der Amplitude $\rho$ und der Phasendrehung $\psi$ in Bezug auf die direkte Welle (komplexer Reflexionsfaktor r $= \rho \cdot e^{-j\psi}$), so vereinfacht sich die Filterform eines nichtrekursiven Filters 36 gemäß der Darstellung in Fig. 2, indem eine große Anzahl der Koeffizienten $h_{1,2}(k)$ bei den Multiplizieren 40 verschwindet. Dies wird dadurch berücksichtigt, daß die Verzögerungszeiten T der einzelnen Verzögerungsspeicher bzw. Zeitglieder 38

3

EP 0 201 758 B1

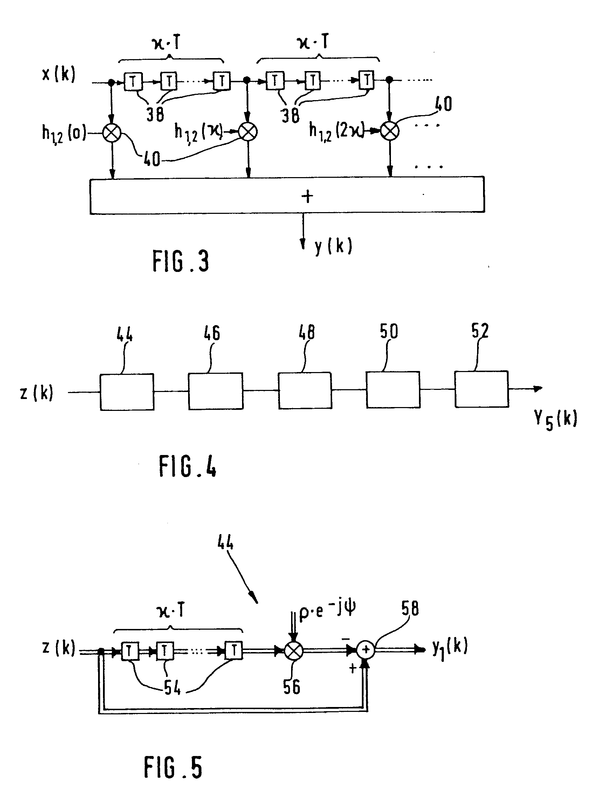

durch $x \cdot T$ ersetzt werden, wobei $x$ den Quotienten aus der Laufzeit $\tau$ der reflektierten Welle und dem Abtastintervall $x = \tau/T$ bezeichnet. In Fig. 3 ist ein entsprechend modifizierter Entzerrerzweig zur kompensation einer Einfachreflektion dargestellt.

Die Berechnung der Entzerrerkoeffizienten erfolgt bei dem vorgeschlagenen Demodulator gemäß der älteren Patentanmeldung durch Minimierung des Fehlers der resultierenden Impulsantwort (minimales Fehlerquadrat). Dies alles ist in der älteren Patentanmeldung näher beschrieben, so daß darauf an dieser Stelle nicht weiter eingegangen zu werden braucht.

Gemäß Fig. 4 sieht die Erfindung für die Kompensation von Mehrwegeempfang nun eine nichtrekursive Kaskadenform mit hier fünf nacheinandergeschalteten Entzerrerblöcken 44,46,48,50 und 52 vor. Ein durch eine Reflexion gestörtes FM-Empfangssignal z(k) führt zu dem Ausgangssignal $y_5$(k), dessen Form nachstehend noch erläutert wird.

Zur besseren Verdeutlichung wird das Mehrwege-Problem komplex formuliert, wobei das durch eine Reflexion gestörte FM-Empfangssignal folgende Form hat:

$$z(k) = e^{j\varphi(k)} + \rho \cdot e^{-j\psi} \, e^{j\varphi(k-\varkappa)} \quad ; \quad \text{mit} \quad \varphi(k) = \Delta\Omega \int\limits_{-\infty}^{kT} v(\xi)d\xi \qquad (1)$$

( $\rho$ = Amplitude, $\psi$ = Phasendrehung, Laufzeit $\tau = x \cdot T$). Dieses Signal wird auf ein System gemäß Fig. 5 gegeben, welches den ersten Entzerrerblock 44 darstellt und Verzögerungsglieder 54, einen Multiplizierer 56 sowie einen Addierer 58 umfaßt. Das Ausgangssignal $y_1$(k) hat dann die Form:

$$y_1(k) = z(k) - \rho e^{-j\psi} \cdot z(k-\varkappa) =$$

$$e^{j\varphi(k)} + \rho \cdot e^{-j\psi} \cdot e^{j\varphi(k-\varkappa)} - \rho \cdot e^{-j\psi} \, e^{j\varphi(k-\varkappa)} - \rho^2 e^{-j2\psi} \, e^{j\varphi(k-2\varkappa)}$$

$$y_1(k) = e^{j\varphi(k)} - \rho^2 \cdot e^{-2j\psi} \, e^{j\varphi(k-2\varkappa)} \quad . \qquad (2)$$

Man erhält also erneut ein durch eine Reflexion gestörtes Signal, wobei nun die Phasendrehung $\psi$ und die Laufzeit $\tau$ verdoppelt sind. Der Reflexionsfaktor beträgt jetzt $\rho^{2}$ welcher gegenüber $\rho$ reduziert ist, wobei hier der Fall $\rho < 1$ angenommen ist.

Der soweit beschriebene Vorgang wird in einem entprechend modifizierten Netzwerk - hier im zweiten Entzerrerblock 46 gemäß Fig. 6 - wiederholt. Das Ausgangssignal $y_2$(k) des zweiten Entzerrerblocks 46 ergibt sich auf Grund der obigen Überlegungen wie folgt:

$$y_2(k) = e^{j\phi(k)} - \rho^4 \, e^{-4j\psi} \, e^{j\psi(k-4x)} \qquad (3)$$

Der Reflexionsfaktor ist jetzt also auf $\rho^4$ reduziert worden. Durch die weiteren Entzerrerblöcke 48,50 und 52 wird dieser Vorgang so oft wiederholt, bis der Reflexionsfaktor hinreichend klein ist. Am Ausgang des n-ten Entzerrerblockes erhält man die nachfolgenden Reflexionsparameter:

$$\rho_n = \rho^{2^n} \quad , \quad \psi_n = 2^n\psi \quad , \quad \varkappa_n = 2^n \cdot \varkappa \quad .$$

Es hat sich gezeigt, daß für praktische Anwendungsfälle in der Regel fünf oder maximal sechs Entzerrerblöcke ausreichen, um eine wirksame Kompensation von Mehrwegeempfang zu erzielen.

Zur weiteren Verdeutlichung ist in Fig. 7 und 8 der Klirrfaktor des demodulierten Signals als Funktion der Anzahl n der Entzerrerblöcke 44 - 52 dargestellt. In Fig. 7 betreffen die unterschiedlichen Kurven jeweils unterschiedliche Reflexionsfaktoren $\rho$, und in Fig. 8 ist der Klirrfaktor K (in Prozent) für unterschiedliche Werte von $x$ ( = Quotient aus der Laufzeit $\tau$ der reflektierten Welle und dem Abtastintervall) gezeigt. Wie man erkennen kann, nimmt der Klirrfaktor K bereits bei fünf Entzerrerblöcken einen verschwindend geringen Wert an.

Ein bedeutsamer Vorteil der Erfindung besteht darin, daß die vorgesehene modifizierte Struktur für die

4

Entzerrer zu einer erheblichen Reduktion des Hardware-Aufwandes führt.

Die Hardware-Struktur eines Entzerrers erhält man, indem man die in Fig. 5 und 6 angewendete komplexe Beschreibung durch reelle Operationen ersetzt. Fig. 9 zeigt in allgemeiner Form den Aufbau eines n-ten Entzerrerblockes.

Die beiden Eingänge des Entzerrerblockes führen jeweils zu einem ersten und einem zweiten Signalweg, die jeweils ein Schieberegister 64 und 66 beinhalten. Der Eingang des Schieberegisters 64 führt zu einem ersten Addierer 78, während der Eingang des anderen Schieberegisters 66 mit einem anderen Addierer 82 verbunden ist.

An das Schieberegister 64 schließen sich zwei Multiplizierer 68 und 70 an. Der erste Multiplizierer 68 ist mit einem ersten Addierer 76 verbunden, während der zweite Multiplizierer 70 mit einem dritten Addierer 80 im zweiten Signalweg in Verbindung steht.

Ferner befindet sich am Ausgang des weiteren Schieberegisters 66 ein dritter Multiplizierer 72, der zu dem dritten Addierer 80 führt, und außerdem ist an den Ausgang des Schieberegisters 66 ein vierter Multiplizierer 74 angeschlossen, welcher mit dem ersten Addierer 76 verbunden ist. Die beiden Multiplizierer 68 und 72 erhalten ferner den gleichen Multiplikator $a_n$.

Anhand eines Vergleiches des bei der Erfindung vorgesehenen Kaskadenentzerrers mit der Transversalstruktur der nichtrekursiven Filter bei dem in der erwähnten älteren Patentanmeldung vorgeschlagenen digitalen Demodulator wird der mit der Erfindung erzielte Vorteil bezüglich des erforderlichen Aufwandes verdeutlicht.

Beim Ansatz von n Kaskadenblöcken bzw. Entzerrerblöcken 44 - 52 sind insgesamt 4n Multiplikationen auszuführen. Ein vergleichbarer Transversalentzerrer besitzt eine Länge von $2^n \cdot x$ und erfordert demgemäß $4 \cdot 2^n$ Multiplikationen. Der durch die bei der Erfindung verwendete Kaskadenstruktur hervorgerufene Multiplikationsgewinn beträgt also

$$G = 2^n/n \; ;$$

Das bedeutet für n = 6 also einen Faktor von 10. Um eieinen ebensolchen Faktor wird die Anzahl der Additionen reduziert. Der Umfang des Zustandsspeichers ist in beiden Fällen gleich, d.h. man benötigt insgesamt eine Verzögerung von $2^n \cdot x$ Takten.

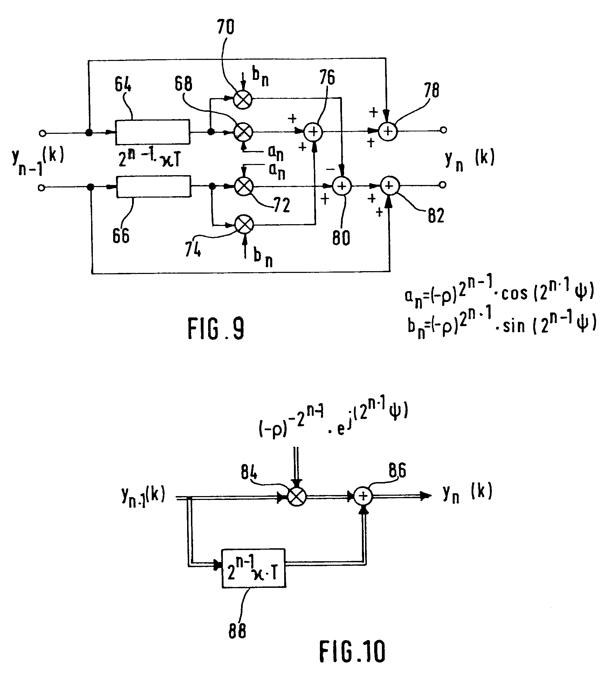

Bei dem soweit beschriebenen Kaskadenentzerrer mit den Entzerrerblöcken 44 - 52 wurde der Fall $\rho < 1$ angenommen. Das Kaskadensystem läßt sich aber auch auf den Fall $\rho > 1$ ausweiten. Dabei ist eine modifizierte Struktur für die einzelnen Entzerrerblöcke zu verwenden, und Fig. 10 zeigt hierzu in schematischer Darstellung einen n-ten Entzerrerblock für $\rho > 1$.

Das Eingangssignal $y_{n-1}(k)$ wird einem Multiplizierer 84 sowie einem Verzögerungsglied 88 zugeführt. An den Multiplizierer 84 schließt sich ein Addierer 86 an, der außerdem mit dem Ausgang des Verzögerungsgliedes 88 verbunden ist.

In dem gemäß Fig. 10 geschilderten Fall ist vor dem ersten Entzerrerblock noch eine Korrekturmultiplikation mit dem Faktor $r^{-1} = \rho^{-1} \cdot e^{+j\psi}$ auszuführen.

## Patentansprüche

1. Demodulator für frequenzmodulierte Signale, die in einem Funkempfänger an der Zwischenfrequenzstufe abnehmbar sind und über einen analogen Bandpaß (14) und einen Analog/Digital-Wandler (16) in digitaler Form in zwei parallelen Zweigen in den Basisbandbereich transformiert werden und im Basisbandbereich jeweils über digitale nichtrekursive Tiefpaßfilter (18 bis 32) und eine Eindeutigkeitsschaltung (34) geleitet werden,
dadurch gekennzeichnet,
das der Bandpaß (14) schmaldbandig mit einer Bandbreite von etwa ± 200 kHz ausgeführt ist und daß die nichtrekursiven Filter zur Kompensation von Mehrwegeempfang als Entzerrernetzwerke mit Kaskadenstruktur (44 bis 52) ausgebildet sind, wobei jeder Entzerrerblock (44; 46; 48; 50; 52) eine Erhöhung der Phasendrehung ($\psi$) und der Laufzeit (r) sowie eine Reduzierung des Reflektionsfaktors ($\phi$) des Eingangssignals (z(k)) bewirkt.

2. Demodulator nach Anspruch 1, dadurch gekennzeichnet, daß der erste Entzerrerblock (44) des Kaskadenentzerrers bei einem durch eine Reflexion gestörtem FM-Empfangssignal der Form

5

EP 0 201 758 B1

$$z(k) = e^{j\varphi(k)} + \rho \cdot e^{-j\psi} e^{j\varphi(k-\varkappa)} \quad ; \quad mit \quad \varphi(k) = \Delta\Omega \int_{-\infty}^{kT} v(\xi)d\xi \qquad (1)$$

ein Ausgangssignal der nachfolgenden Form besitzt:

$$y_1(k) = z(k) - \rho e^{-j\psi} \cdot z(k-\varkappa) =$$

$$e^{j\varphi(k)} + \rho \cdot e^{-j\psi} \cdot e^{j\varphi(k-\varkappa)} - \rho \cdot e^{-j\psi} e^{j\varphi(k-\varkappa)} - \rho^2 e^{-j2\psi} e^{j\varphi(k-2\varkappa)}$$

$$y_1(k) = e^{j\varphi(k)} - \rho^2 \cdot e^{-2j\psi} e^{j\varphi(k-2\varkappa)} \qquad . \qquad\qquad (2)$$

mit folgenden Bedeutungen: $\Delta\Omega =$ Kreisfrequenz-Hub; v(t) = modulierendes NF-Signal; $\rho =$ Amplitude der reflektierten Welle; $\psi =$ Phasendrehung der reflektierten Welle; $\tau = \varkappa \cdot T =$ Laufzeit; T = Abtastintervall; $\rho$ = Winkel; $\varkappa$ = Quotient aus Laufzeit der reflektierten Welle und dem Abtastintervall.

**3.** Demodulator nach Anspruch 2, dadurch gekennzeichnet, daß das Ausgangssignal des auf den ersten Entzerrerblock (44) folgenden zweiten Entzerrerblockes (46) die nachfolgende Form hat:

$$y_2(k) = e^{j\phi(k)} - \rho^4 e^{-4j\psi} e^{j\phi(k-4x)} \qquad (3)$$

**4.** Demodulator nach einem der vorhergehenden Ansprüche 1 - 3, dadurch gekennzeichnet, daß am Ausgang des n-ten Entzerrerblockes die folgenden Reflexionsparameter vorliegen:

$$\rho_n = \rho^{2^n} \quad , \quad \psi_n = 2^n \psi \quad , \quad \varkappa_n = 2^n \cdot \varkappa \quad .$$

**5.** Demodulator nach einem der vorhergehenden Ansprüche 1 - 4, dadurch gekennzeichnet, daß der Kaskadenentzerrer fünf bis sechs Entzerrerblöcke (44-52) umfaßt.

**6.** Demodulator nach einem der vorhergehenden Ansprüche 1 - 5, dadurch gekennzeichnet, daß der Entzerrerblock (44;46;48;50;52) in zwei Signalwegen je ein Schieberegister (64;66) enthält, dem jeweils ein erster (68) und ein zweiter (70) bzw. ein dritter (72) und vierter Multiplizierer (74) sowie ein erster (76) und ein zweiter Addierer (78) bzw. ein dritter (80) und vierter Addierer (82) nachgeschaltet sind.

**7.** Demodulator nach Anspruch 6, dadurch gekennzeichnet, daß das dem ersten Schieberegister (64) zugeführte Signal ($y_{n-1}$ (k)) zugleich dem zweiten Addierer (78) und das dem zweiten Schieberegister (66) zugeführte Signal zugleich dem vierten Addierer (82) zugeführt ist.

**8.** Demodulator nach Anspruch 6 und/oder 7, dadurch gekennzeichnet, daß der Ausgang des ersten Schieberegisters (64) über den zweiten Multiplizierer (70) mit dem dritten Addierer (80) und der Ausgang des zweiten Schieberegisters (66) über den vierten Multiplizierer (74) mit dem ersten Addierer (76) verbunden sind.

**9.** Demodulator nach einem der vorhergehenden Ansprüche 1 - 8, dadurch gekennzeichnet, daß der Entzerrerblock für den Fall einer Amplitude $\rho > 1$ einen ersten Signalweg mit einem Multiplizierer (84) sowie einen zweiten Signalweg mit einem Verzögerungsglied (88) umfaßt, wobei der Multiplizierer (84) und das Verzögerungsglied (88) mit einem gemeinsamen Addierer (86) verbunden sind.

**10.** Demodulator nach Anspruch 9, dadurch gekennzeichnet, daß vor dem ersten Entzerrerblock eine

6

Korrekturmultiplikation um den Faktor $\rho$ vorgesehen ist.

**Claims**

1. Demodulator for frequency-modulated signals which can be picked up at the intermediate-frequency stage in a radio receiver and, via an analog bandpass filter (14) and an analog/digital converter (16) are transformed, in digital form, into the baseband range in two parallel branches and, in the baseband range, are in each case conducted via digital non-recursive low-pass filters (18 to 32) and a uniqueness circuit (34), characterised in that the bandpass filter (14) is constructed with a narrow bandwidth of about ±200 kHz and in that the non-recursive filters are constructed as equaliser networks having a cascade structure (44 to 52) for compensating for multi-path reception, each equaliser block (44; 46; 48; 50; 52) effecting an increase in the phase rotation ($\psi$) and the transit time ($\tau$) and a reduction in the reflection factor ($\phi$) of the input signal (z(k)).

2. Demodulator according to Claim 1, characterised in that, with a received FM signal, disturbed by reflection, of the form

$$z(k) = e^{j\varphi(k)} + \rho \cdot e^{-j\psi} e^{j\varphi(k-\varkappa)} \quad ; \quad \text{mit} \quad \varphi(k) = \Delta\Omega \int_{-\infty}^{kT} v(\xi)d\xi \quad (1)$$

the first equaliser block (44) of the cascade equaliser has an output signal of the following form:

$$y_1(k) = z(k) - \rho e^{-j\psi} \cdot z(k-\varkappa) =$$

$$e^{j\varphi(k)} + \rho \cdot e^{-j\psi} \cdot e^{j\varphi(k-\varkappa)} - \rho \cdot e^{-j\psi} e^{j\varphi(k-\varkappa)} - \rho^2 e^{-j2\psi} e^{j\varphi(k-2\varkappa)}$$

$$y_1(k) = e^{j\varphi(k)} - \rho^2 \cdot e^{-2j\psi} e^{j\varphi(k-2\varkappa)} \quad .$$

$$(2)$$

with the following meanings: $\Delta\Omega$ = angular-frequency deviation; v(t) = modulating AF signal; $\rho$ = amplitude of the reflected wave; $\psi$ = phase rotation of the reflected wave; $\tau = \varkappa \cdot T$ = transit time; T = sampling interval; $\phi$ = angle; $\varkappa$ = quotient of transit time of the reflected wave and the sampling interval.

3. Demodulator according to Claim 2, characterised in that the output signal of the second equaliser block (46) following the first equaliser block (44) has the following form:

$$y_2(k) = e^{j\phi(k)} - \rho^4 e^{-4j\psi} e^{j\phi(k-4x)} \quad (3)$$

4. Demodulator according to one of the preceding Claims 1-3, characterised in that the following reflection parameters are present at the output of the nth equaliser block:

$$\rho_n = \rho 2^n \ , \ \psi_n = 2^n \psi \ , \ \varkappa_n = 2^n \cdot \varkappa \ .$$

5. Demodulator according to one of the preceding Claims 1-4, characterised in that the cascade equaliser comprises 5 to 6 equaliser blocks (44-52).

6. Demodulator according to one of the preceding Claims 1-5, characterised in that the equaliser block (44; 46; 48; 50; 52) contains in each of two signal paths a shift register (64; 66), which is in each case followed by a first (68) and a second (70) and, respectively, a third (72) and fourth multiplier (74) and by a first (76) and a second adder (78) and, respectively, a third (80) and fourth adder (82).

7. Demodulator according to Claim 6, characterised in that the signal ($y_{n-1}$ (k)) supplied to the first shift register (64) is supplied at the same time to the second adder (78) and the signal supplied to the second shift register (66) is supplied at the same time to the fourth adder (82).

8. Demodulator according to Claim 6 and/or 7, characterized in that the output of the first shift register (64) is connected via the second multiplier (70) to the third adder (80) and the output of the second shift register (66) is connected via the fourth multiplier (74) to the first adder (76).

9. Demodulator according to one of the preceding Claims 1-8, characterized in that the equalizer block comprises a first signal path with a multiplier (84) and a second signal path with a delay section (88) for the case of an amplitude $\rho > 1$, the multiplier (84) and the delay section (88) being connected to a common adder (86).

10. Demodulator according to Claim 9, characterized in that a correction multiplication by the factor $\rho$ is provided before the first equalizer block.

**Revendications**

1. Démodulateur pour des signaux modulés en fréquence et qui proviennent de l'étage de fréquence intermédiaire d'un récepteur radio et sont transformés par un filtre passe-bande analogique (14) et un convertisseur analogique/numérique (16) sous une forme numérique dans deux branches parallèles dans la plage de la bande de base et dans cette plage ils passent par des filtres passe bas numériques non récurrents (18-32) et un circuit d'exclusion logique (34), démodulateur caractérisé en ce que : le filtre passe-bande (14) est un filtre à bande étroite avec une largeur de bande de l'ordre + 200 kHz et le filtre non récurrent compensant la réception par chemins multiples est un circuit de correction à structure en cascade (44-52), et chaque bloc de correction (44, 46, 48, 52) augmente la rotation de phase ($\psi$) et le temps de parcours ($\tau$) et réduit le coefficient de réflexion ($\phi$) du signal d'entrée (z(k)).

2. Démodulateur selon la revendication 1, caractérisé en ce que le premier bloc de correction (44) du circuit de correction en cascade qui recevant un signal de réception (MF) déformé par une réflexion et qui a la forme suivante :

$$z(k) = e^{j\varphi(k)} + \rho \cdot e^{-j\psi} e^{j\varphi(k-\varkappa)} \quad ; \text{ avec } \quad \varphi(k) = \Delta\Omega \int_{-\infty}^{kT} v(\xi)d\xi \qquad (1)$$

fournit un signal de sortie de forme suivante :

$$y_1(k) = z(k) - \rho e^{-j\psi} \cdot z(k-\varkappa) =$$

$$e^{j\varphi(k)} + \rho \cdot e^{-j\psi} \cdot e^{j\varphi(k-\varkappa)} - \rho \cdot e^{-j\psi} e^{j\varphi(k-\varkappa)} - \rho^2 e^{-j2\psi} e^{j\varphi(k-2\varkappa)}$$

$$y_1(k) = e^{j\varphi(k)} - \rho^2 \cdot e^{-2j\psi} e^{j\varphi(k-2\varkappa)} \qquad . \qquad (2)$$

dans cette formule $\Delta\Omega$ = fréquence circulaire- course ; v(t) = signal BF modulé ; $\rho$ amplitude de l'onde réfléchie ; $\varkappa$ rotation de phase de l'onde réfléchie ; $\tau = \varkappa \cdot T$ = temps de parcours ; T = intervalle de détection ; $\phi$ = angle ; $\psi$ = quotient du temps de parcours de l'onde réfléchie et de l'intervalle de détection.

3. Démodulateur selon la revendication 2, caractérisé en ce que le signal de sortie du second bloc de correction (46) suivant le premier bloc de correction (47) à la forme suivante :

$$y_2(k) = e^{j\phi(k)} - \rho^4 e^{-4j\psi} e^{j\phi(k-4x)} \qquad (3)$$

4. Démodulateur selon l'une des revendications précédentes, 1-3, caractérisé en ce qu'à la sortie du enième bloc de correction, on a les paramètres de réflexion suivantes :

$$\rho_n = \rho^{2^n} \quad , \quad \psi_n := 2^n \psi \quad , \quad x_n = 2^n \cdot x \quad .$$

5. Démodulateur selon l'une des revendications précédentes 1-4, caractérisé en ce que le circuit de correction en cascade comprend cinq à six blocs de correction (44-52).

6. Démodulateur selon l'une des revendications précédentes 1-5, caractérisé en ce que le bloc de correction (44, 46, 48, 50, 52) comporte dans deux chemins de signaux, chaque fois un registre à décalage (64, 66) suivi respectivement d'un premier (68) et d'un second (70) ainsi que d'un troisième et d'un quatrième multiplicateur (74) ainsi que d'un premier (76) et d'un second additionneur (78) ou d'un troisième (80 et d'un quatrième additionneur (82).

7. Démodulateur selon la revendication 6, caractérisé en ce que le signal ($y_{n-1}$ (k) fourni au premier registre à décalage (64) est appliqué en même temps au second additionneur (78) et en ce que le signal appliqué au second registre à décalage (66) est fourni en même temps au quatrième additionneur (82).

8. Démodulateur selon la revendication 6 et/ou 7, caractérisé en ce que la sortie du premier registre à décalage (64) est reliée par le second multiplicateur (70) au troisième additionneur (80) et la sortie du second registre à décalage (66) est reliée par le quatrième multiplicateur (74) au premier additionneur (76).

9. Démodulateur selon l'une des revendications précédentes 1-8, caractérisé en ce que dans le cas d'une amplificateur $\rho > 1$, le bloc de correction comporte un premier chemin de signal avec un multiplicateur (84) ainsi qu'un second chemin de signal avec un élément de temporisation (88) et le multiplicateur (84) et l'élément de temporisation (88) sont reliés à un additionneur commun (86).

10. Démodulateur selon la revendication 9, caractérisé en ce qu'en amont du premier bloc de correction, il est prévu une multiplication de correction par le facteur ($\rho$).

FIG.1

FIG.2

FIG.3

FIG.4

FIG.5

FIG .6

$$2 \varkappa \cdot T$$

$$\rho^2 e^{-2j\psi}$$

$y_1(k)$ · → T → T → ··· → T → ⊗ → + ⊕ + → $y_2(k)$

54   56   58

46

FIG. 7

K/‰

24
22
20
18
16
14
12
10
8
6
4
2
0

$\rho = 0.9$

$\rho = 0.7$

$\rho = 0.5$

0   1   2   3   4   5   6

(EZ:$\varkappa$=10 $\psi$=45°)   Anzahl der Blöcke

FIG. 8

K/‰

28
26
24
22
20
18
16
14
12
10
8
6
4
2
0

$\varkappa = 20$

$\varkappa = 15$

$\varkappa = 10$

$\varkappa = 5$

0   1   2   3   4   5   6

(EZ:$\rho$=0,9 $\psi$=0°)   Anzahl der Blöcke

**FIG.9**

$$a_n = (-\rho)^{2^{n-1}} \cdot \cos(2^{n-1}\psi)$$
$$b_n = (-\rho)^{2^{n-1}} \cdot \sin(2^{n-1}\psi)$$

$$(-\rho)^{-2^{n-1}} \cdot e^{j(2^{n-1}\psi)}$$

**FIG.10**